# EUROPEAN PATENT APPLICATION

(11) **EP 1 482 557 A2**
(43) Date of publication of application: **01.12.2004**
(21) Application number: 04012765.6
(22) Date of filing: 28.05.2004
(51) Int. Cl.: H01L 27/146

(54) **Solid state imaging device**

(30) Priority: 30.05.2003 JP 2003155346
(71) Applicant: MATSUSHITA ELECTRIC INDUSTRIAL CO., LTD., Kadoma-shi, Osaka 571-8501 (JP)
(72) Inventor: Mori, Mitsuyoshi, Kyoto-shi Kyoto 607-8146 (JP)
(74) Representative: Grünecker, Kinkeldey, Stockmair & Schwanhäusser Anwaltssozietät

(57) **Abstract**

A read-out pulse line for supplying a signal for switching is provided in common for transfer gates provided for each of ones of photoelectric diode (PD) sections located in a pair of adjacent rows. The transfer gates are switched by the read-out pulse line, charges of the ones of PD sections are transferred to different floating diffusion (FD) sections, and created charges are detected by each pixel amplifier provided so as to correspond to each of the FD sections. Thus, pixel signals of a pair of rows can be obtained simultaneously on output signal lines.

## Description

### BACKGROUND OF THE INVENTION

The present invention relates to a solid state imaging device in which a plurality of photoelectric conversion sections for photoelectrically converting incident light.

Floating diffusion amplifier type MOS image sensors have been known. In a known floating diffusion amplifier type MOS image sensor, a photoelectric conversion cell including four transistor gates and five interconnects is used (See Japanese Laid-Open Publication No. 11-274455) in general.

Moreover, there have been floating diffusion amplifiers including a photoelectric conversion cell with a structure which has been devised for the purpose of reduction in the power consumption of a MOS image sensor and improvement of the aperture ratio of the MOS image sensor (see US 2002/0122128 A1 and US 2002/0122130 A1).

Assume that the photoelectric conversion cell including four transistor gates and five interconnects has, for example, an area of 4.1 µm × 4.1 µm. When a design is made using the 0.35 µm rule, the aperture ratio of the photoelectric conversion section made of photo diode is only about 5%.

### SUMMARY OF THE INVENTION

It is therefore an object of the present invention to improve, with focus on photoelectric conversion cells located in adjacent rows, the aperture ratio of photoelectric conversion sections in each of the photoelectric conversion cells.

To achieve the object, according to the present invention, a solid state imaging device includes: a plurality of photoelectric conversion sections arranged in a two-dimensional manner; floating diffusion (FD) sections to which charges of said photoelectric conversion sections are transferred; transfer gates for transferring the charges of said photoelectric conversion sections; pixel amplifiers for detecting potentials of the FD sections; and output signal lines to which detection signals of the pixel amplifiers are output. In the solid state imaging device, a read-out line for supplying a signal for switching the transfer gates is provided in common for the transfer gates provided for each of ones of the photoelectric conversion sections located in a pair of adjacent rows, the transfer gates are switched via the common read-out line, charges of each of ones of the photoelectric conversion sections located in the pair of adjacent rows are transferred to the FD sections so that charges from different photoelectric conversion sections are transferred to different FD sections, and the created charges are detected by the pixel amplifiers provided so as to correspond to the FD sections.

According to the present invention, the respective numbers of transistors and interconnects per photoelectric conversion cell can be reduced, thus resulting in improvement of the aperture ratio of the photoelectric conversion sections. Moreover, read out operation is performed for every two rows, so that charges from all of the photoelectric conversion cells can be read out for a short time.

### BRIEF DESCRIPTION OF THE DRAWINGS

FIG. **1** is a circuit diagram illustrating an exemplary configuration of a solid state imaging device according to the present invention.
FIG. **2** is a wave-form chart showing drive timing for the solid state imaging device of FIG. **1**.
FIG. **3** is a partial cross-sectional view of the solid state imaging device of FIG. **1**.
FIG. **4** is a block diagram of a camera module using the solid state imaging device of FIG. **1**.

### DESCRIPTION OF THE PREFERRED EMBODIMENTS

Hereafter, a solid state imaging device according to an embodiment of the present invention will be described in detail with reference to the accompanying drawings.

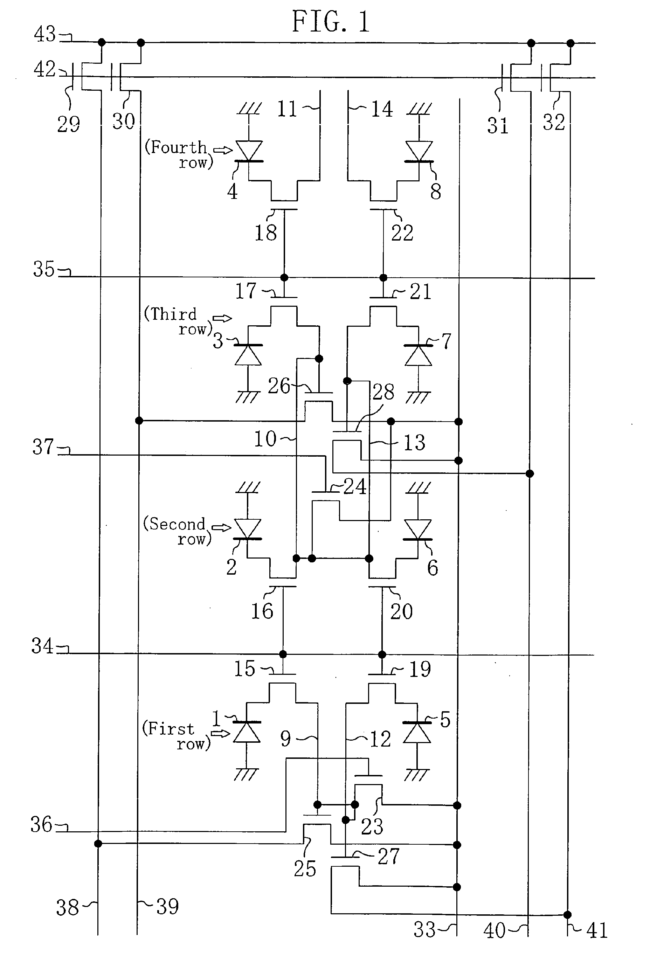

FIG. **1** illustrates an exemplary configuration of a solid state imaging device according to the present invention. In FIG. 1, each of the reference numerals **1** through **8** denotes a photo diode (PD) section for performing photoelectric conversion. Floating diffusion (FD) sections **9** through **14** for accumulating charges which have been photoelectrically converted are arranged so that each of the FD sections is adjacent to an associated one of the PD sections **1** through **8**. Charges are transferred from each of the PD sections **1** through **8** to an associated one of the FD sections **9** through **14** via an associated one of transfer gates **15** through **22**. Each of reset gates **23** and **24** for discharging charges are connected to the FD sections **9** through **14**. Moreover, the FD sections **9** through **14** are connected to respective gates of pixel amplifiers **25** through **28** for detecting charges of the FD sections. Load transistors **29** through **32** constitute source follower amplifiers together with the pixel amplifiers **25** through **28**.

In FIG. **1**, the reference numeral **33** denotes a cell power supply line (VDDCELL), the reference numerals **34** and **35** denote read-out pulse lines (READ) for applying a pulse voltage to the transfer gates **15** through **22**, the reference numerals **36** and **37** denote reset pulse lines (RESET) for discharging charges of the FD sections **9** through **14**, the reference numerals **38** through **41** denote output signal lines for transmitting detection voltages of the FD sections **9** through **14**, the reference numeral **42** denotes a load gate line for applying a signal to each of respective gates of the load transistors **29** through **32**, and the reference numeral **43** denotes a source power supply for the load transistors **29** through **32**.

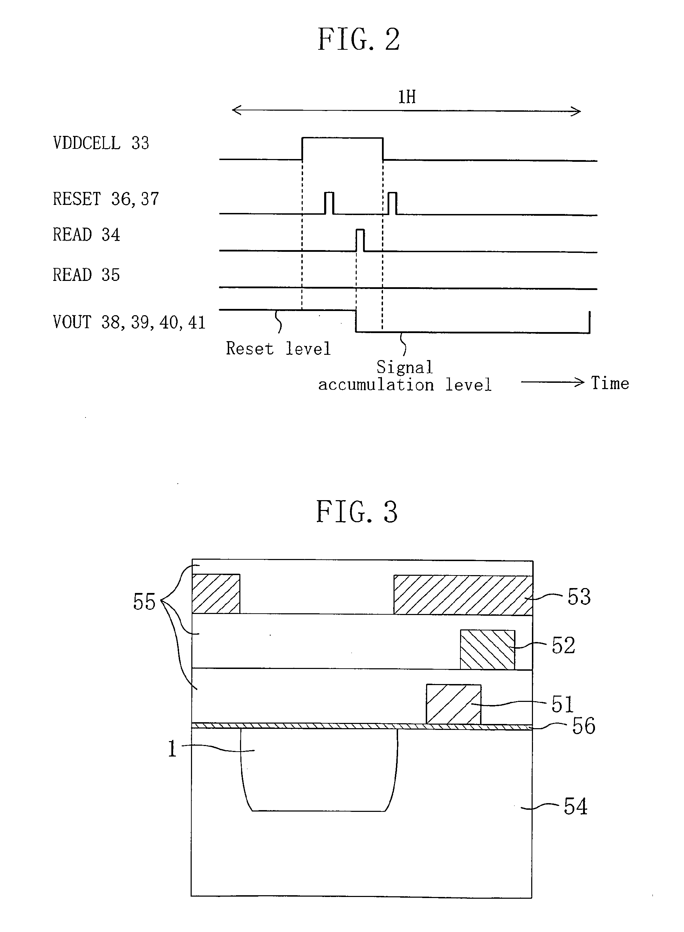

FIG. **2** shows drive timing in a horizontal blanking period for the solid state imaging device of FIG. **1**. Signal charges are detected for photoelectric conversion cells arranged in the first and second rows in a horizontal blanking period and then for photoelectric conversion cells arranged in the third and fourth rows in the next horizontal blanking period. In this manner, signal charge detection is performed for two rows at a time. In this signal charge detection, detection of signal charges is performed to two rows simultaneously.

First, charges of the PD sections **1, 5, 2** and **6** in the first and second rows are transferred. To transfer charges of the PD sections **1, 5, 2** and **6**, predetermined voltages are applied to the load gate line **42** and the source power supply line **43**, respectively, so that each of the load transistors **29, 30, 31** and **32** becomes a constant current source. Next, after the cell power supply line **33** has been made HIGH, the reset pulse lines **36** and **37** are made HIGH to turn the reset gates **23** and **24** ON, thereby discharging charges of the FD sections **9, 10, 12** and **13**. At this time, a signal level at a reset time is detected by each of the pixel amplifiers **25, 26, 27** and **28**, and then a black level signal is clamped in a noise cancel circuit (not shown) via the output signal lines **38, 39, 40** and **41**.

Next, after the reset pulse lines **36** and **37** have been made LOW to turn the reset gates **23** and **24** OFF, a HIGH voltage is applied to the read-out pulse line **34** to turn the transfer gates **15, 16, 19** and **20** ON. Thus, charges accumulated in each of the PD sections **1, 2, 5** and **6** are transferred to an associated one of the FD sections **9, 10, 12** and **13**. For the charges transferred to the FD sections **9, 10, 12** and **13**, signal accumulation levels are detected by the pixel amplifiers **25, 26, 27** and **28** and then signal sampling is performed in the noise cancel circuit via each of the output signal lines **38, 39, 40** and **41**. By this operation, output signals from which the variation in threshold and noise components of the pixel amplifiers **25, 26, 27** and **28** are removed can be detected.

Next, when the cell power supply line **33** is made LOW and, at the same time, the reset pulse lines **36** and **37** are made HIGH to turn the reset gates **23** and **24** ON, the potential of each of the FD sections **9, 10, 12** and **13** is set at the LOW level of the cell power supply line **33** and each of the pixel amplifiers **25, 26, 27** and **28** becomes to be out of operation. After this, the pixel amplifiers **25, 26, 27** and **28** are out of operation until the read-out pulse line **34** is selected in a vertical line scanning circuit (not shown), thus resulting in a non-selective state. Then, in the next horizontal blanking period, using the same timing, charges of the PD sections **3, 4, 7** and **8** located in the third and fourth rows are detected from the output signal lines **38, 39, 40** and **41**.

As has been described, with the configuration of FIG. **1**, the read-out pulse line **34** for supplying a signal for switching is provided in common for the transfer gates **15, 16, 19** and **20** each provided for each of ones of the PD sections **1, 2, 5** and **6** located in a pair of adjacent rows. Thus, by switching each of the transfer gates by the read-out pulse line **34**, charges of ones of the PD sections located in the pair of adjacent rows are transferred to the FD sections **9, 10, 12** and **13** so that charges of different PD sections are transferred to different FD sections, and then the created charges are detected by the pixel amplifiers **25**, **26, 27** and **28** provided so as to correspond to the FD sections, respectively. Thus, the number of read-out lines per photoelectric conversion cell can be reduced, thus resulting in reduction in a cell size. Moreover, pixel signals in the pair of rows can be obtained on the output signal lines **38, 39, 40** and **41** at the same time. Thus, charges from all of the photoelectric conversion cells on the solid state imaging device can be read out at high speed.

Moreover, the FD sections **10** and **13** and the pixel amplifiers **26** and **28** are provided in common for the PD sections **2** and **6** located in one of the pair of adjacent rows and the PD sections **3** and **7** in a row which does not make the pair with the PD sections **1** and **5**. Thus, the respective numbers of the FD sections and pixel amplifiers per photoelectric conversion cell can be reduced.

Moreover, the pixel amplifiers **25** and **27** sharing a drain region are provided for ones of the PD sections **1** and **5** which are arranged in the same row and are adjacent to each other, respectively, and charges are detected from each of the pixel amplifiers to an associated one of the output signal lines **38** and **41**. Thus, the number of drain regions per photoelectric conversion cell can be reduced.

Specifically, by adopting the circuit configuration of FIG. **1**, the respective numbers of transistors and interconnects per photoelectric conversion cell are estimated at 1.75 and 2.75, respectively. For example, assume that each of the photoelectric conversion cell has an area of 4.1 µm × 4.1 µm. When a design is made using the 0.35 µm rule, the aperture ratio of the PD sections **1** through **8** is as high as 30%.

Moreover, the reset gate **23** for resetting the respective potentials of the FD sections **9** and **12** is further provided. Thus, it is possible to stop signal transfer from the pixel amplifiers **25** and **27** after signals from the PD sections **1** and **5** are detected to the output signal lines **38** and **41**. Note that this reset gate **23** is capable of resetting the FD sections **9** and **12** for transferring charges of the PD sections **1** and **5** located in the first row at the same time. Moreover, another reset gate **24** is capable of resetting the FD sections **10** and **13** for transferring charges of the PD sections **2, 3, 6** and **7** located in the second and third rows at the same time.

Moreover, a region in which the FD sections **9** through **14** and the pixel amplifiers **25** through **28** are provided and a region in which the read-out pulse lines **34** and **35** are provided are alternately arranged. Thus, the PD sections **1** through **8** can be arranged with an equal pitch therebetween, so that a homogenous image can be obtained in a simple manner.

FIG. **3** is a partial cross-sectional view of the solid state imaging device of FIG. **1**. As shown in FIG. **3**, the PD section **1** and the like are formed on a silicon substrate **54** and a gate electrode (polysilicon film) **51** is formed on a gate oxide film **56**. Then, a first layer metal line **52** and a second layer metal line **53** are provided with an interlevel film **55** interposed between the gate electrode **51** and the first layer metal line **52** and between the first and second layer metal lines **52** and **53.** In this case, the second layer metal line **53** functioning as the cell power supply line **33** also serves as a light shielding film for the FD sections **9** through **14.** If the cell power supply line **33** is formed on a different plane from a plane in which the output signal lines **38** through **41** are provided in the above-described manner, the aperture ratio can be further improved. When a design is made under the same condition as the above-described condition, the aperture ratio of the PD sections 1 through **8** is as high as 32%, thus resulting in improvement of sensitivity.

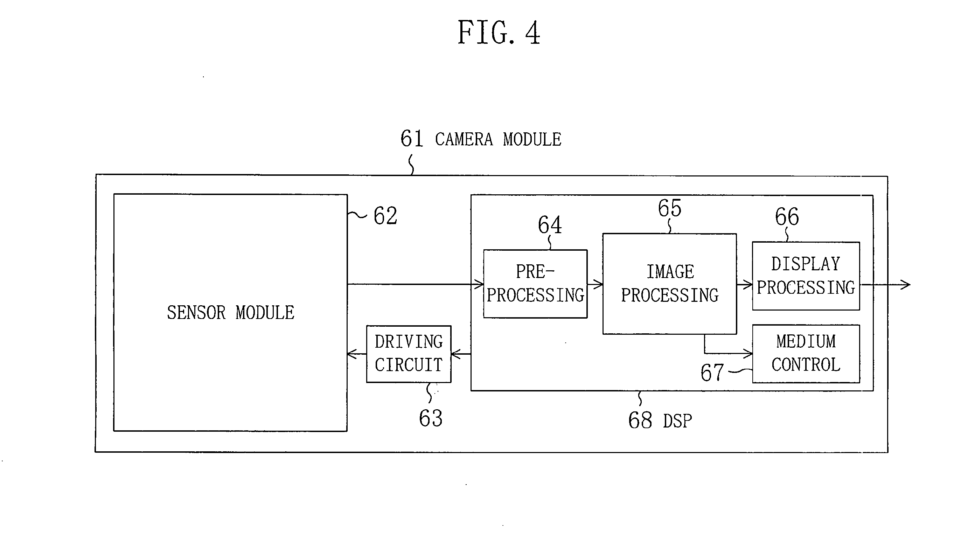

FIG. **4** is a block diagram of a camera module **61** using the solid state imaging device of FIG. **1** as a sensor module **62**. The camera module **61** of FIG. **4** includes the sensor module **62** having the configuration of FIG. **1**, a driving circuit **63** for transmitting a signal for driving the sensor module **62**, and a digital signal processor (DSP) **68** for processing signals read out from the sensor module **62** via the output signal lines **38** through **41** shown in FIG. **1**. The signals read out from the sensor module **62** are temporarily accumulated in a pre-processing section **64** of the DSP **68**. In the sensor module **62**, accumulated charges of the PD sections **1** through **8** are read out for two rows at a time. Thus, the same number of memory elements as the number of pixels in two rows are provided in the pre-processing section **64**. An output from the pre-processing section **64** is converted into a color image in an image processing circuit **65** which is the same image processing circuit used in a known image processing circuit and is replaced with a signal to be displayed on a display in a display processing circuit **66.** Moreover, an image of the sensor module **62** can be saved in a recording medium by the medium control circuit **67**.

As has been described, a solid state imaging device according to the present invention allows reduction in the respective numbers of transistors and interconnects per photoelectric conversion cell, thus resulting in reduction in the size of photoelectric conversion cells.

## Claims

1. A solid state imaging device comprising:
a plurality of photoelectric conversion sections arranged in a two-dimensional manner;
floating diffusion (FD) sections to which charges of said photoelectric conversion sections are transferred;
transfer gates for transferring the charges of said photoelectric conversion sections;
pixel amplifiers for detecting potentials of the FD sections; and
output signal lines to which detection signals of the pixel amplifiers are output,
wherein a read-out line for supplying a signal for switching the transfer gates is provided in common for the transfer gates provided for each of ones of the photoelectric conversion sections located in a pair of adjacent rows, the transfer gates are switched via the common read-out line, charges of said each of ones of the photoelectric conversion sections located in the pair of adjacent rows are transferred to the FD sections so that charges from different photoelectric conversion sections are transferred to different FD sections, and the created charges are detected by the pixel amplifiers provided so as to correspond to the FD sections.

2. The solid state imaging device of claim 1, wherein the FD sections and the pixel amplifiers are provided in common for ones of the photoelectric conversion sections located in one of the pair of adjacent rows and ones of the photoelectric conversion sections located in another row.

3. The solid state imaging device of claim 1, wherein respective pixel amplifiers using a common drain region are provided for adjacent ones of the photoelectric conversion sections located in the same row and charges from different pixel amplifiers are detected to different output signal lines.

4. The solid state imaging device of claim 1, further comprising reset means for resetting potentials of the FD sections.

5. The solid state imaging device of claim 1, wherein a region in which the FD sections and the pixel amplifiers are provided and a region in which the read-out line is provided are alternately arranged.

6. The solid state imaging device of claim 1, wherein a power supply line of the pixel amplifiers also serves as a light shielding film of the FD sections.

7. The solid state imaging device of claim 1, further comprising a signal processing circuit for processing signals on said output signal lines.
